# EUROPEAN PATENT SPECIFICATION

(11) **EP 1 171 338 B1**
(45) Date of publication and mention of the grant of the patent: **14.05.2003**
(21) Application number: 00919067.9
(22) Date of filing: 12.04.2000
(51) Int. Cl.: B61L 1/18, G01R 19/20, G01R 15/18

(54) **CURRENT SENSOR**
STROMSENSOR
CAPTEUR DE COURANT

(30) Priority: 16.04.1999 GB 9908599
(43) Date of publication of application: 16.01.2002
(73) Proprietor: AEA Technology plc, Oxfordshire OX11 0RA (GB)
(72) Inventor: SUTTON, Malcolm Stuart, Borrowash, Derby DE72 3GN (GB)
(74) Representative: Mansfield, Peter Turquand
(86) International application number: GB0001398
(87) International publication number: WO00063057

(56) References cited:
- EP-A- 0 356 171
- CH-A- 419 338
- DE-A- 3 940 932
- FR-A- 2 731 974
- US-A- 5 501 417
- RIPKA P ET AL: "PRECISE DC CURRENT SENSORS" PROCEEDINGS OF THE INSTRUMENTATION AND MEASUREMENT TECHNOLOGY CONFERENCE (IMTC),US,NEW YORK, IEEE, 4 June 1996 (1996-06-04), pages 1479-1483, XP000642756 ISBN: 0-7803-3313-6

## Description

This invention relates to a non-contact method of, and instrument for, sensing and measuring a current, particularly but not exclusively a current which may be less than 1 A.

The instrument may be used, for example, to measure and monitor the current flowing in a track circuit. A track circuit detects the presence of a train in a section of track by applying a low DC voltage between the rails, and detecting the change in the resistance between the rails due to the presence of a train as the wheels and axles provide electrical connection between the rails. The DC electrical current which flows in the track circuit when a train is present is typically less than 1 A, and may be in the range 1 mA - 100 mA, and measuring such currents in a non-contact fashion (and so without modifying the track circuit) is difficult because the magnetic field of such a small DC current is significantly less than the earth's magnetic field.

A non-contact instrument for measuring electrical currents is described in CH 419 338 (University of Southampton et al), and similar instruments are described in DE 39 40 932 A (Dorr) and in EP 0 356 171 A (University of British Columbia). The latter describes an instrument for sensing and measuring a current in a conductor, the instrument comprising two rings of magnetic material arranged to surround the conductor, each ring carrying an energising winding, the energising windings being arranged to carry an alternating current and arranged to magnetise the rings with the same magnetising force (H) but in opposite directions, and a sensing winding connected to a current indicator, the sensing winding being arranged to respond to the sum of the magnetic fluxes in the two rings, the magnitude of the alternating current supplied to the energising windings being sufficiently large to ensure that the magnetic flux density (B) in each of the rings varies in a non-linear manner with the instantaneous value of the alternating current.

The present invention provides such an instrument, wherein the frequency of the alternating current supplied to the energising windings is at least twice that of any alternating current to be measured in the conductor, and wherein the current indicator is arranged to integrate the values of the voltage induced in the sensing windings over a predetermined part of each successive cycle of the alternating current supplied to the energising windings.

The earth's magnetic field, considered over a small region, is essentially a plane field inclined at the angle of dip below the horizontal (e.g. 67° in southern England), whereas the magnetic field due to the current in the conductor is a circular field around the conductor. Although the earth's magnetic field will be distorted by the presence of the railway track and any trains, this geometrical distinction can still be used to distinguish between the two sources of magnetic field. The two rings of magnetic material are therefore desirably close enough together that the earth's magnetic field is substantially the same for each ring. In the preferred arrangement the rings are coaxial and next to each other, separated only by the thickness of the electrical windings and insulation.

The magnetic material forming the rings ensures that the relationship between electric current and magnetic flux density (B) is non-linear. The material desirably has a high magnetic permeability, as this enhances the sensitivity of the instrument. The benefits of high permeability would be significantly reduced if there were any air gaps in the magnetic circuit, so preferably each ring is a continuous ring, and may be of laminated form wound from a continuous tape. Alternatively each ring may comprise part rings (e.g. two C-shaped half rings) which can be assembled around the conductor; in this case the mating faces of the part rings are desirably machined smooth so when assembled there is no significant air gap. Ideally the magnetic material would have an almost rectangular hysteresis (B/H) graph, which exhibits sudden magnetic saturation and has a high magnetic remanence, but practical materials can only approximate to this.

The instrument is capable of measuring DC currents, and AC currents of low frequency (ideally up to half the frequency of the alternating current source). It may be used to detect currents flowing in an electric cable, in which case the rings must be large enough for the cable to pass through them, and might for example be of 20 mm internal diameter. Alternatively it may be used to detect the track circuit current flowing through an axle of a train, in which case each ring must be large enough to surround the axle, and be of say 200 mm internal diameter.

The alternating emf connected to the energising windings might be sinusoidal, or more preferably square wave. The frequency is preferably sufficiently low that each ring is driven from saturation in one direction to saturation in the reverse direction in each cycle, and so is usually less than 10 kHz, more preferably less than 1000 Hz, but preferably at least 100 Hz. Reaching saturation has the advantage that the end points of the magnetic cycle are well-defined. If the rings were identical, and no current were flowing in the conductor, then there would be no signal supplied to the current indicator. Current flowing in the conductor will augment the magnetic flux in one ring while decreasing the flux in the other ring, and because of the non-linear characteristics of the rings there will then be a signal supplied to the current indicator. If the magnetic material in the rings had an ideal rectangular hysteresis curve one would expect a pulse output as one ring reaches saturation slightly before the other. In practice the output signals supplied to the current indicator are more complex, but nevertheless can be related to the current in the conductor.

In a second aspect, the invention provides a method of sensing and measuring a current in a conductor, using such an instrument.

The invention will now be further and more particularly described, by way of example only, and with reference to the accompanying drawings in which:
Figure 1 shows a diagrammatic view of an instrument for measuring the current in a conductor, partly showing the instrument in perspective;
Figure 2 shows an electrical circuit diagram for the instrument of figure 1;
Figures 3a and 3b show graphically the output voltage signals, plotted against time, obtained with the instrument of figure 1 at different values of current in the conductor;
Figure 4 shows graphically the variation in output signal with current for an instrument as in figure 1; and
Figure 5 shows graphically the variation in output signal with current for an instrument as in Figure 1, after integration of the voltage signal.

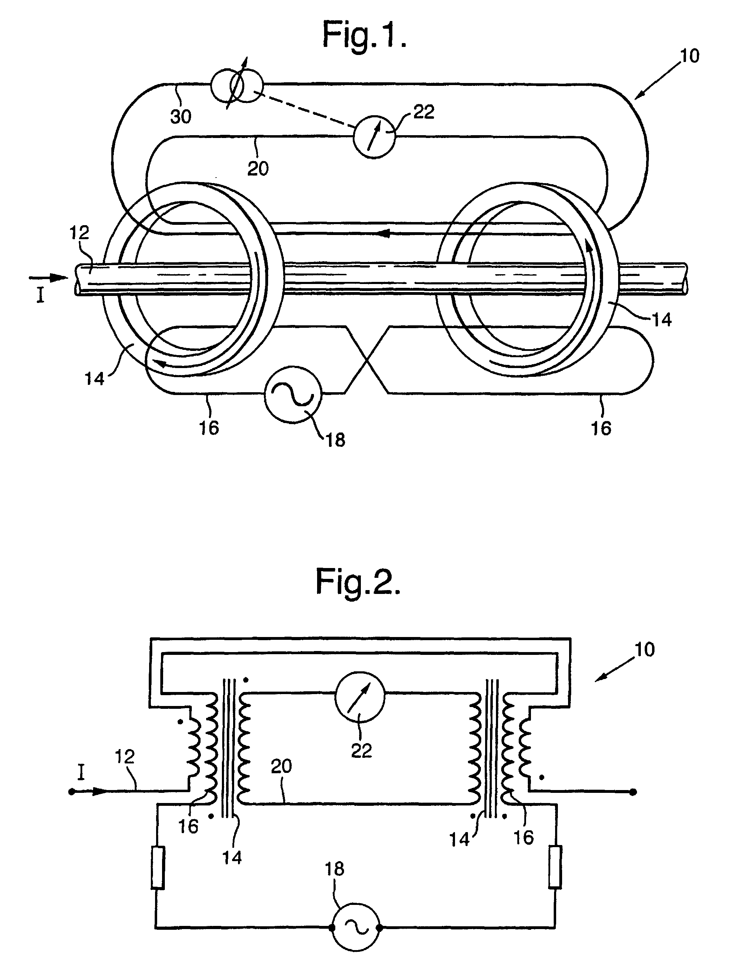

Referring to figures 1 and 2, an instrument 10 for sensing and monitoring DC currents in a cable 12 of external diameter 15 mm comprises two rings 14 each of internal diameter 20 mm, through which the cable 12 passes. The rings 14 are substantially identical, and each is wound from a 0.05 mm thick tape of mumetal, so it is of laminated form (mumetal is an alloy of approximate composition Fe 18%, Ni 75%, Cu 5%, and Cr 2%). Onto each ring 14 is wound a respective toroidal energising coil 16 (only one turn being shown in figure 1), of insulated wire, the coils 16 being connected in series with each other and connected to a source 18 of AC energising current. The coils 16 are arranged so the magnetising forces (H) in the rings 14 due to the energising current are equal, but are in opposite directions. Although shown spaced apart in the figures, the rings 14 are placed next to each other, separated only by the windings 16. A sensing winding 20 is then overwound around both rings 14 together (only one turn is shown in figure 1). The magnetic flux enclosed by the winding 20 is consequently the sum of the magnetic fluxes in the two rings 14, and any changes in that sum will generate a voltage in the winding 20. It will be appreciated that this is equivalent to winding separate sensing coils 20 around each ring 14 and then connecting these coils in series, as shown in the circuit diagram of figure 2. The sensing winding 20 is connected to a current indicator 22.

In use of the instrument 10, the source 18 provides a square wave alternating voltage to the energising coils 16, which in this case is at a frequency of 750 Hz. The instrument is effectively an AC bridge network, and an output signal from the sensing winding 20 only occurs if there is a difference between the magnetic fluxes in the two rings 14. This happens if there is a current in the conductor 12, as this increases the flux in one ring 14 and decreases the flux in the other ring 14. Because of the non-linear characteristics of the magnetic material, the increase and the decrease will not be the same, and so there will be a voltage induced in the sensing winding 20. This frequency of AC current is such that each ring 14 is driven to saturation on each half cycle, using a peak current of 100 mA. (As excitation frequency is increased, the time available for saturating the magnetic material decreases, and therefore energy would have to be introduced at a greater rate. For a given number of turns in the energising windings 16, this may be achieved by adjusting the drive current, but there is no benefit in increasing the power consumption. Other considerations involved in selecting this frequency are that, in principle, one measurement of the current in the conductor 12 may be made per cycle; for accuracy it is preferable to average over a number of cycles. To enable measurements of currents in the conductor 12 up to say 10 Hz, the excitation frequency must therefore be at least 20 Hz and is preferably at least 40 Hz. To avoid potential interference from other electrical appliances it is desirable to select a frequency which is a multiple of mains frequency, i.e. 50 Hz in Europe.)

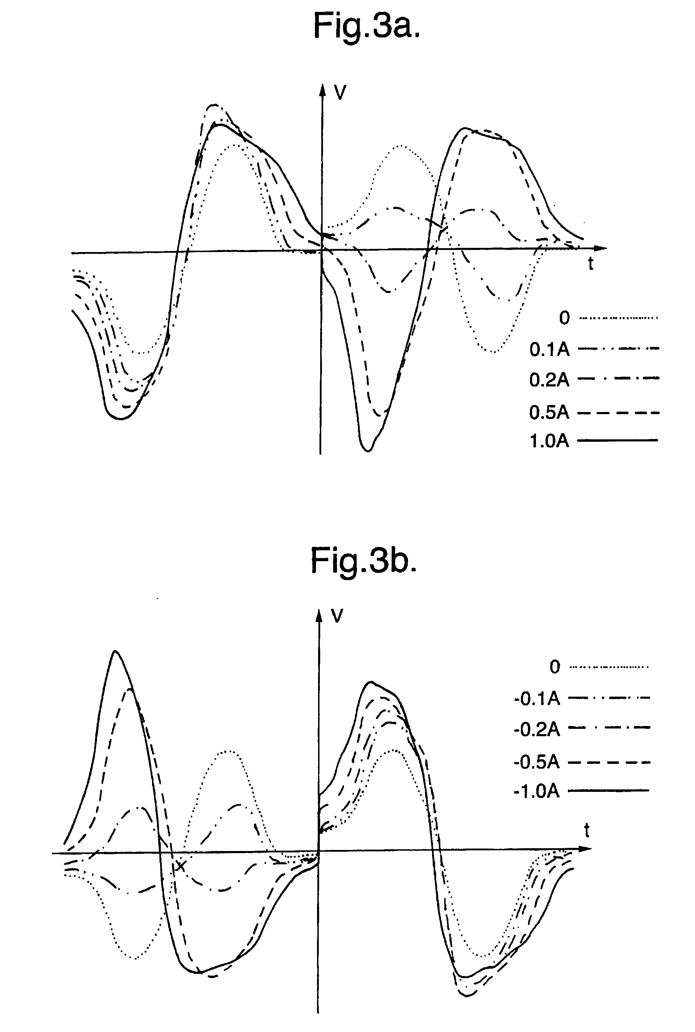

The voltage induced in the sensing winding 20 may be detected in a variety of ways, and be related to the current in the conductor 12. Referring now to figures 3a and 3b, these show graphically the variation of the induced voltage V with time t (through a cycle of the square wave energising voltage), for different values of electric current I in the conductor 12, as observed with the instrument 10 described above. Figure 3a shows the results obtained using positive values of current I, and figure 3b shows the results obtained with negative values of current I, being shown separately only for clarity. It will be observed that the induced voltage V varies in a complex fashion through each cycle, but that the graphs obtained with different values of current can be clearly distinguished; in figure 3a the differences are most marked on the right hand side of the graph, whereas in figure 3b the differences are most marked on the left hand side. The detailed shape of these graphs depends on the shape of the hysteresis curve for the material of the rings 14, and may also differ for rings of different dimensions.

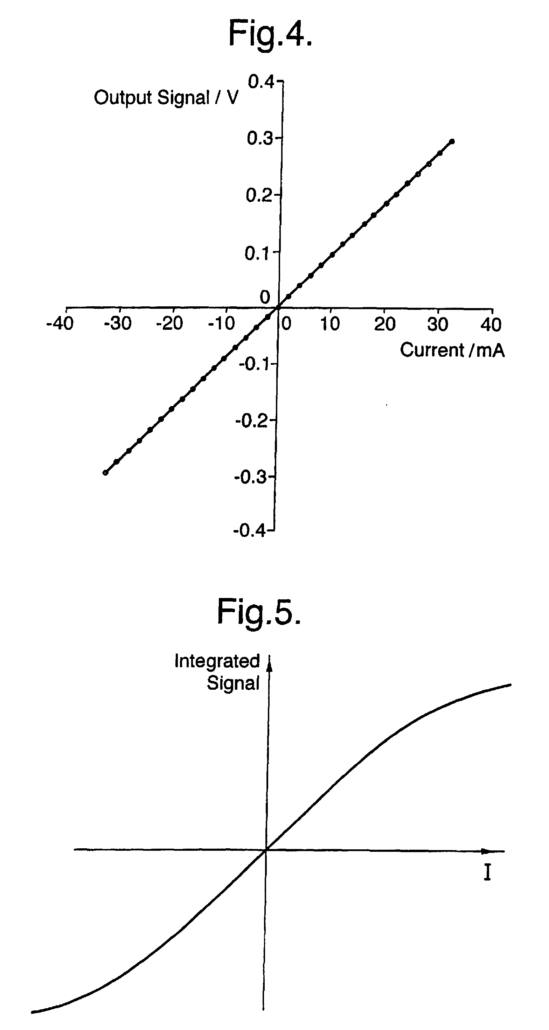

A modified current sensing instrument has been made, differing from that described above in that the rings 14 of mumetal tape were wound onto plastic formers of internal diameter 200 mm, this being large enough that an axle can pass through the rings 14. The energising coils 16 and the sensor coils 20 were wound as described above. The energising coils 16 were supplied with a 750 Hz square wave, with a peak energising current of 100 mA. The current indicator 22 in this case comprised a time gate, a filter and an output amplifier connected to a voltmeter. The time gate in this case was synchronized with the energising signal, and arranged to select only the voltage signal at a well defined point in the cycle; the resulting signal was filtered to remove the 750 Hz switching frequency; and the resulting DC signal was amplified (by x10) to obtain convenient readings on a digital voltmeter. Referring now to figure 4, there are shown graphically the readings on the digital voltmeter for a range of different values of current flowing in a conductor 12 passing through the rings 14. It will be observed that in this particular case there is a generally linear relationship between the output voltage and the current over this range of currents.

An alternative and preferable way of determining the current I from the measurements of induced voltage V involves integrating the induced voltage V over parts of the cycle, as this provides an output which is less sensitive to any timing errors. The preferred approach is to carry out this integration through the first and third quarters of each cycle. This may be performed using analogue electronics in the current indicator 22 of Figure 1, with a solid state switch to control the times for which the voltage signal is supplied to the integrator, and a sample-and-hold circuit to output the result of the integration at the end of each cycle. This signal processing generates an output signal which, as shown in Figure 5 to which reference is now made, varies monotonically with the current I, and is linear over a wide range of currents I.

Referring again to Figure 1, the instrument 10 can be further improved by providing a feedback winding 30 driven by the output from the current indicator 22, the magnetic field of the current in the feedback winding 30 opposing the field of the current in the cable 12. The feedback winding 30 may have many turns, so the feedback current at balance may be many times less than the current in the cable 12. The variation with time of the flux in the rings 14 is thereby maintained near the zero-current condition, which has the beneficial effect of making operation of the instrument 10 substantially independent of the magnetic circuit characteristics. Furthermore the range of currents which can be measured is increased, being limited only by the capability of supplying a balancing current to the feedback winding 30. The sensitivity of the instrument 10 with feedback is dominated by the characteristics of the feedback, and is therefore much less dependent on the magnetic characteristics of the rings 14. With such a feedback system, the current in the feedback winding 30 provides a measure of the current in the cable 12.

It should be appreciated that, in principle, feedback may be provided in this way in any instrument 10 in which the output voltage V (as shown in Figures 3a and b) has first been processed to provide a single-value output signal corresponding to a particular value of current I in the cable 12. The preferred instrument 10, as described above, integrates the induced voltage over the first and third quarters of each cycle, and also includes the feedback winding 30. Incorporation of an integrating mechanism with feedback in this way essentially makes the instrument 10 self-zeroing. With a square wave energising frequency of 750 Hz supplied to the coils 16, the instrument 10 can measure both the DC current in the cable 12, and any variations in that current, up to a frequency of about 200 Hz.

It will also be appreciated that the voltage signals may be analyzed in a variety of different ways in addition to those described above, and in particular they might instead be analyzed digitally.

## Claims

1. An instrument for sensing and measuring a current in a conductor (12), the instrument (10) comprising two rings (14) of magnetic material arranged to surround the conductor (12), each ring (14) carrying an energising winding (16), the energising windings (16) being arranged to carry an alternating current (18) and arranged to magnetise the rings (14) with the same magnetising force but in opposite directions, and a sensing winding (20) connected to a current indicator (22), the sensing winding (20) being arranged to respond to the sum of the magnetic fluxes in the two rings (14), the magnitude of the alternating current supplied to the energising windings (16) being sufficiently large to ensure that the magnetic flux density in each of the rings (14) varies in a non-linear manner with the instantaneous value of the alternating current, wherein the frequency of the alternating current supplied to the energising windings (16) is at least twice that of any alternating current to be measured in the conductor (12), and wherein the current indicator (22) is arranged to integrate the values of the voltage induced in the sensing windings (20) over a predetermined part of each successive cycle of the alternating current supplied to the energising windings (16).

2. An instrument as claimed in claim 1 wherein the rings (14) are coaxial and next to each other, separated only by the thickness of the electrical windings (16, 20) and insulation.

3. An instrument as claimed in claim 1 or claim 2 wherein the source (18) of the alternating current supplied to the energising windings (16) has a square wave variation of emf with time.

4. An instrument as claimed in any one of the preceding claims wherein the magnitude of the alternating current supplied to the energising windings (16) is sufficiently large that each ring (14) is driven from saturation in one direction to saturation in the reverse direction in each cycle of the alternating current.

5. An instrument as claimed in any one of the preceding claims wherein the alternating current supplied to the energising windings (16) is of a frequency in the range 100 Hz to 1000 Hz.

6. An instrument as claimed in any one of the preceding claims also including a feedback winding (30) and means to generate a current in the feedback winding, arranged so that the magnetic field due to the current in the feedback winding (30) has the opposite effect to the magnetic field of the current in the conductor (12), the feedback current being such that the current indicator (22) is maintained close to the state corresponding to zero current in the conductor (12).

7. A method for sensing and measuring a current in a conductor (12), the method comprising installing two rings (14) of magnetic material around the conductor (12), each ring (14) carrying an energising winding (16), the energising windings being arranged to carry an alternating current (18), and arranged to magnetise the rings (14) with the same magnetising force but in opposite directions, and a sensing winding (20) connected to a current indicator (22), the sensing winding (20) being arranged to respond to the sum of the magnetic fluxes in the two rings (14), the magnitude of the alternating current supplied to the energising windings (16) being sufficiently large to ensure that the magnetic flux density in each of the rings (14) varies in a non-linear manner with the instantaneous value of the alternating current, wherein the frequency of the alternating current supplied to the energising windings (16) is at least twice that of any alternating current to be measured in the conductor (12), and wherein the current indicator (22) provides an output signal corresponding to the values of the voltage induced in the sensing windings (20) integrated over a predetermined part of each successive cycle of the alternating current supplied to the energising windings (16).

8. A method as claimed in claim 7 wherein the rings (14) also include a feedback winding (30) connected to means to generate a current in the feedback winding, and arranged so that the magnetic field due to the current in the feedback winding (30) has the opposite effect to the magnetic field of the current in the conductor (12), and the method includes maintaining the feedback current such that the current indicator (22) is maintained close to the state corresponding to zero current in the conductor (12).

9. A method as claimed in claim 7 or claim 8 wherein the output signal corresponds to the said values integrated over the first and third quarters of each successive cycle.

## Patentansprüche

1. Ein Instrument zur Abtastung bzw. zum Fühlen und zur Messung eines Stroms in einem Leiter (12), wobei das Instrument (10) zwei Ringe (14) aus magnetischem Material aufweist, welche so angeordnet bzw. eingerichtet sind, dass sie den Leiter (12) umgeben, wobei jeder Ring (14) eine Erregerwicklung (16) trägt, wobei die Erregerwicklungen (16) so angeordnet bzw. eingerichtet sind, dass sie einen Wechselstrom (18) führen und so angeordnet bzw. eingerichtet sind, dass die Ringe (14) mit der gleichen magnetischen Feldstärke magnetisiert werden, jedoch in entgegengesetzten Richtungen, und eine Abtast- bzw. Fühlwicklung (20), welche an einen Stromanzeiger bzw. -indikator (22) angeschlossen ist, wobei die Abtast- bzw. Fühlwicklung (20) so angeordnet bzw. eingerichtet ist, dass sie auf die Summe der magnetischen Flüsse in den beiden Ringen (14) anspricht, wobei die Größe der Wechselströme, welche den Erregerwicklungen (16) zugeführt werden, ausreichend groß sind, um sicherzustellen, dass die Dichte des magnetischen Flusses in jedem der Ringe sich in einer nicht-linearen Weise mit dem Momentanwert des Wechselstroms ändert, wobei die Frequenz des den Erregerwicklungen (16) zugeführten Wechselstroms wenigstens zweimal so groß ist, wie diejenige irgend eines zu messenden Wechselstroms in dem Leiter (12) und wobei der Stromanzeiger bzw. -indikator (22) so angeordnet bzw. eingerichtet ist, dass er die Werte der in den Abtast- bzw. Fühlwicklungen (20) induzierten Spannung über einen vorbestimmten Teil eines jeden aufeinanderfolgenden Zyklus des den Erregerwicklungen (16) zugeführten Wechselstroms integriert.

2. Ein Instrument, wie in Anspruch 1 beansprucht, wobei die Ringe (14) koaxial und nahe zueinander sind und nur durch die Dicke der elektrischen Wicklungen (16, 20) und der Isolation voneinander separiert bzw. getrennt sind.

3. Ein Instrument wie in Anspruch 1 oder 2 beansprucht, wobei die Quelle (18) für den den Erregerwicklungen (16) zugeführten Wechselstrom eine Rechteckwellenveränderung der elektromotorischen Kraft (EMK) über der Zeit hat.

4. Ein Instrument wie in irgendeinem der vorherigen Ansprüche beansprucht, wobei die Größe des Wechselstroms, welcher den Erregerwicklungen (16) zugeführt wird, ausreichend groß ist, dass jeder Ring (14) von der Sättigung in einer Richtung in die Sättigung in der umgekehrten Richtung bei jedem Zyklus des Wechselstroms getrieben wird.

5. Ein Instrument wie in irgendeinem der vorhergehenden Ansprüche beansprucht, wobei der den Erregerwicklungen (16) zugeführte Wechselstrom eine Frequenz in dem Bereich von 100 Hz bis 1000 Hz aufweist.

6. Ein Instrument wie in irgendeinem der vorhergehenden Ansprüche beansprucht, welches auch eine Rückkopplungswicklung (30) aufweist, sowie Einrichtungen zur Erzeugung eines Stroms in der Rückkopplungswicklung und wobei die Einrichtung zur Anordnung so angeordnet bzw. eingerichtet ist, dass das magnetische Feld infolge des Stroms in der Rückkopplungswicklung (30) den entgegengesetzten Effekt zu dem magnetischen Feld des Stroms in dem Leiter (12) hat, wobei der Rückkopplungsstrom derart ist, dass der Stromanzeiger bzw. -indikator (22) nahe dem Zustand entsprechend Nullstrom in dem Leiter (12) gehalten wird.

7. Ein Verfahren zum Abtasten bzw. Fühlen und Messen eines Stroms in einem Leiter (12), wobei das Verfahren aufweist: Das Installieren zweier Ringe (40) aus magnetischem Material um den Leiter (12), wobei jeder Ring (14) eine Erregerwicklung (16) trägt, wobei die Erregerwicklungen so angeordnet bzw. eingerichtet sind, dass sie einen Wechselstrom (18) führen und so angeordnet bzw. eingerichtet sind, dass sie die Ringe (14) mit der gleichen magnetischen Feldstärke magnetisieren, aber in entgegengesetzten Richtungen und wobei eine Abtast- bzw. Fühlwicklung (20) mit einem Stromanzeiger bzw. -indikator (22) verbunden ist, wobei die Abtast- bzw. Fühlwicklung (20) so angeordnet bzw. eingerichtet ist, dass sie auf die Summe der magnetischen Flüsse in den beiden Ringen (14) anspricht, wobei die Größe des zu den Erregerwicklungen (16) geführten Wechselstroms ausreichend groß ist, um sicherzustellen, dass die Dichte des magnetischen Flusses in jedem der Ringe (14) sich in einer nicht-linearen Weise über dem Momentanwert des Wechselstroms ändert, wobei die Frequenz des den Erregerwicklungen (16) zugeführten Wechselstroms wenigstens das zweifache derjenigen irgendeines anderen in dem Leiter (12) zu messenden Wechselstroms ist und wobei der Stromanzeiger bzw. -indikator (22) ein Ausgangssignal schafft, welches den Werten der in den Abtast- bzw. Fühlwicklungen (20) induzierten Spannung entspricht, die über einen vorbestimmten Teil von jedem aufeinanderfolgenden Zyklus des den Erregerwicklungen (16) zugeführten Wechselstroms integriert sind.

8. Verfahren wie in Anspruch 7 beansprucht, wobei die Ringe (14) auch eine Rückkopplungswicklung (30) einschließen, welche an Einrichtungen zur Erzeugung eines Stroms in der Rückkopplungswicklung angeschlossen sind und welche so angeordnet bzw. eingerichtet ist, dass das magnetische Feld infolge des Stroms in der Rückkopplungswicklung (30) den entgegengesetzten Effekt wie das Magnetfeld des Stroms in dem Leiter (12) hat und das Verfahren weiterhin das Aufrechterhalten des Rückkopplungsstroms derart einschließt, dass der Stromanzeiger bzw. -indikator 22 nahe dem Zustand entsprechend dem Nullstrom in dem Leiter (12) aufrechterhalten wird.

9. Ein Verfahren wie in Anspruch 7 oder Anspruch 8 beansprucht, wobei das Ausgangssignal den besagten über den ersten und dritten Quartalen bzw. Vierteln jedes aufeinanderfolgenden Zyklus integrierten Werten entspricht.

## Revendications

1. Instrument pour détecter et mesurer un courant dans un conducteur (12), l'instrument (10) comprenant deux anneaux (14) de matériau magnétique disposés de manière à entourer le conducteur (12), chaque anneau (14) portant un enroulement d'excitation (16), les enroulements d'excitation (16) étant disposés de manière à transporter un courant alternatif (18) et disposés de manière à magnétiser les anneaux (14) avec la même force de magnétisation mais dans des directions opposées, et un enroulement de détection (20) connecté à un indicateur de courant (22), l'enroulement de détection (20) étant disposé de manière à répondre à la somme des flux magnétiques dans les deux anneaux (14), l'amplitude du courant alternatif appliqué aux enroulements d'excitation (16) étant suffisamment grande pour assurer que la densité de flux magnétique dans chacun des anneaux (14) varie de manière non linéaire avec la valeur instantanée du courant alternatif, dans lequel la fréquence du courant alternatif délivré aux enroulements d'excitation (16) est au moins deux fois celle de n'importe quel courant alternatif à mesurer dans le conducteur (12), et dans lequel l'indicateur de courant (22) est disposé de manière à intégrer les valeurs de la tension induite dans les enroulements de détection (20) sur une partie prédéterminée de chaque cycle successif du courant alternatif appliqué aux enroulements d'excitation (16).

2. Instrument selon la revendication 1, dans lequel les anneaux (14) sont coaxiaux et proches l'un de l'autre, séparés uniquement par l'épaisseur des enroulements électriques (16, 20) et de l'isolation.

3. Instrument selon la revendication 1 ou la revendication 2, dans lequel la source (18) du courant alternatif appliqué aux enroulements d'excitation (16) a une variation rectangulaire de la FEM dans le temps.

4. Instrument selon l'une quelconque des revendications précédentes, dans lequel l'amplitude du courant alternatif appliqué aux enroulements d'excitation (16) est suffisamment grande pour que chaque anneau (14) soit conduit de la saturation dans une direction à la saturation dans la direction inverse dans chaque cycle du courant alternatif.

5. Instrument selon l'une quelconque des revendications précédentes, dans lequel le courant alternatif appliqué aux enroulements d'excitation (16) a une fréquence dans la plage de 100 Hz à 1000 Hz.

6. Instrument selon l'une quelconque des revendications précédentes, comprenant également un enroulement de contre-réaction (30) et des moyens pour générer un courant dans l'enroulement de contre-réaction, disposé de telle manière que le champ magnétique dû au courant dans l'enroulement de contre-réaction (30) a l'effet opposé au champ magnétique du courant dans le conducteur (12), le courant de contre-réaction étant tel que l'indicateur de courant (22) est maintenu proche de l'état correspondant à un courant nul dans le conducteur (12).

7. Procédé pour détecter et mesurer un courant dans un conducteur (12), la méthode comprenant l'installation de deux anneaux (14) de matériau magnétique autour du conducteur (12), chaque anneau (14) portant un enroulement d'excitation (16), les enroulements d'excitation (16) étant disposés de manière à transporter un courant alternatif (18), et disposés de manière à magnétiser les anneaux (14) avec la même force de magnétisation mais dans des directions opposées, et un enroulement de détection (20) connecté à un indicateur de courant (22), l'enroulement de détection (20) étant disposé de manière à répondre à la somme des flux magnétiques dans les deux anneaux (14), l'amplitude du courant alternatif appliqué aux enroulements d'excitation (16) étant suffisamment grande pour assurer que la densité de flux magnétique dans chacun des anneaux (14) varie de manière non linéaire avec la valeur instantanée du courant alternatif, dans laquelle la fréquence du courant alternatif délivré aux enroulements d'excitation (16) est au moins deux fois celle de n'importe quel courant alternatif à mesurer dans le conducteur (12), et dans laquelle l'indicateur de courant (22) délivre un signal de sortie correspondant aux valeurs de la tension induite dans les enroulements de détection (20) intégrée sur une partie prédéterminée de chaque cycle successif du courant alternatif appliqué aux enroulements d'excitation (16).

8. Procédé selon la revendication 7, dans laquelle les anneaux (14) comprennent aussi un enroulement de contre-réaction (30) connecté à des moyens pour générer un courant dans l'enroulement de contre-réaction, et disposés de telle sorte que le champ magnétique dû au courant dans l'enroulement de contre-réaction (30) ait l'effet opposé au champ magnétique du courant dans le conducteur (12), et la méthode comprend le maintien du courant de contre-réaction de telle sorte que l'indicateur de courant (22) soit maintenu proche de l'état correspondant à un courant nul dans le conducteur (12).

9. Procédé selon la revendication 7 ou la revendication 8, dans laquelle le signal de sortie correspond auxdites valeurs intégrées pendant les premier et troisième quarts de chaque cycle successif.
